# EUROPEAN PATENT APPLICATION

(11) **EP 2 457 668 A1**
(43) Date of publication of application: **30.05.2012**
(21) Application number: 11191309.1
(22) Date of filing: 30.11.2011
(51) Int. Cl.: B05B 12/08

(54) **Material dispensing device and method for controlled dispensing**

(30) Priority: 30.11.2010 NL 2005787; 30.11.2010 US 418333 P
(71) Applicant: Blue Nederland B.V., 5753 PA Deurne (NL)
(72) Inventor: van Dinter, Adrianus Leonardus Cornelis Maria, 5752 AK Deurne (NL)
(74) Representative: Dohmen, Johannes Maria Gerardus

(57) **Abstract**

The present invention relates to a material dispensing device (1) and a method for the controlled delivery to an object (17) of a material (8) from a material storage container (7) in which the material (8) is kept at an operating pressure so as to provide a material flow (5). The material dispensing device (1) further comprises a flow meter (4) and a pressure control element (9) for controlling the operating pressure at the material (8) in the material storage container (7) on the basis of the dispensed (12) amount of material (8) measured or determined by means of the flow meter (4). A number of material dispensing devices (1) may be combined into a single material dispensing system.

## Description

### Field of the Invention

The present invention generally relates to applying a material, such as a coat of lacquer, an adhesive coating or another liquid or viscous substance, such as silicones, resins, epoxies and the like, or a gas or a gas mixture, to an object, for example for carefully cleaning or treating the object or parts of an object.

### Background

The dispensing or delivery of a material to an object is a process which takes place in many branches of industry. It is for example used in coating Printed Circuit Boards (PCBs) with an insulation layer, coating an object with a lacquer or paint, applying an adhesive layer or adhesive tracks, applying a barrier or sealing layer to housings, choking components, etc. In many of these cases it is necessary that a predetermined amount of material be dispensed, for example in order to effect a homogeneous (as regards thickness) distribution of a coating or a coat of paint or, for example, for the fail-safe filling of cavities, such as vias in a PCB or hollow spaces under components on a PCB, with a material.

In practice various automated material dispensing devices are known in particular for the delivery of material to relatively small-sized objects, i.e. objects having dimensions ranging from a few mm to a few dozen mm, which devices comprise a material storage container for keeping a material at an operating pressure so as to provide a flow of material.

Due to ambient conditions, such as changes in temperature and humidity level, and variations in the composition of the material, fouling of system components and the like, the amount of material dispensed at a specified operating pressure is not constant.

US patent US 6,692,572 describes such a material dispensing device for the delivery of a material to an object, which device inter alia comprises a metering valve incorporated in the material flow and a flow meter for measuring an amount of material dispensed by the material flow. Based on the dispensed amount of material measured by the flow meter, the metering valve is controlled to dispense a set amount of material with optimum accuracy.

A metering valve as described in the aforesaid US patent is a mechanism for controlling the material flow, for example by allowing material to flow without impediment from the material storage container or by blocking the flow partially or entirely. Such metering valves have one or more components that move in the material flow, i.e. parts which are in direct contact with the material flow.

As a result of the physical contact with the material flow, moving parts in the material flow are not only subject to wear, but they also become fouled or affected upon contact with an aggressive material, for example, or with an adhesive or the like. The life of such a metering valve to a high degree determines the effective working life of the device and therefore constitutes a limiting factor as regards the use of the device. Necessary maintenance and replacement of the metering valve increase the operating costs of the device.

Another drawback of components or parts which come into contact with a material flow is the fact that they may undesirably affect the material flow, for example because small particles of the parts or components find their way into the material flow, as a consequence of which the quality and composition of the material to be dispensed are undesirably affected. Preventing this generally requires the use of components having a special composition, which significantly increases the cost of such metering valves.

The metering valve used in the aforesaid US patent also exhibits these drawbacks.

### Summary

Accordingly it is an object of the invention to propose a configuration for a material dispensing device and a material dispensing method by means of which the delivery of a material can take place in a controlled manner, such that the life of the material dispensing device in its entirety is prolonged, which configuration also provides a possibility of preventing undesirable interaction affecting the composition of the material flow.

In order to accomplish that object, the invention, according to a first aspect thereof, provides a material dispensing device for the controlled dispensing at an object of a material, comprising a material storage container for keeping a material at an operating pressure so as to provide a material flow, and a flow meter for measuring an amount of material dispensed by the material flow, characterised in that the material dispensing device further comprises a pressure control element for controlling the operating pressure at the material in the material storage container on the basis of the measured dispensed amount of material.

The invention is based on the perception that by influencing the operating pressure exerted on the material in the material storage container, the amount of material dispensed by the material dispensing device can be precisely controlled. This makes it possible to refrain from the use of a metering valve in the material flow itself, as a result of which not only the life of the material dispensing device in its entirety is prolonged, but also any interaction affecting the composition of the material flow is effectively prevented.

The material dispensing device according to the present invention is suitable for dispensing all kinds of materials, both low and high-viscous or gaseous. In principle, it is the viscosity of the material that determines whether the material is suitable for use in the material dispensing device. A guideline in this regard may be that materials having a viscosity in the order of 5000 Centipoise or lower, including fluids as well as gases, are quite suitable.

In the material dispensing device according to the invention, the pressure at the material in the material container is controlled by means of a pressure control element which is arranged for controlling the operating pressure at the material in the material storage container on the basis of the measured dispensed amount of material.

To keep the material in the material storage container at an operating pressure, the invention, in an embodiment thereof, provides that the material dispensing device comprises a pressure vessel containing a pressure fluid, which is coupled to the material storage container, which functions to keep the material in the material storage container at the aforesaid operating pressure by means of the pressure fluid.

According to the invention, controlling the operating pressure on the material in the material storage container can be effected in an efficient manner in an embodiment in which the pressure control element is coupled to the pressure vessel, being arranged for controlling the operating pressure exerted at the material in the material storage container by means of the pressure fluid. That is, the operating pressure at the material, and thus on the amount of material dispensed with the material flow, can be effectively varied by introducing or discharging pressure fluid, such as air or another gas, for example an inert gas, or a gas mixture into or from the material storage container.

The use of, for example, an inert gas has the advantage that no undesirable interaction of the fluid in the pressure vessel with the material in the material storage container will take place. Instead of a gas, any other type of pressure fluid may be used, providing that the pressure fluid will not mix with the material in the material storage container. Depending on the material in the material storage container, the pressure fluid may be a liquid as well as a gas.

Generally the operating pressure can be considered to be made up of a fixed or static pressure component and a variable or dynamic pressure component, the pressure control element being arranged for controlling the dynamic pressure component.

The static operating pressure is the fixed or set pressure that is exerted on the material in the material storage container, and the dynamic operating pressure may be regarded as the controlled operating pressure, superposed on the static operating pressure. In practice, for example in coating an object, the static operating pressure may have a value between 0 and 9 bar, whilst the dynamic operating pressure only amounts to a fraction thereof, for example 0.01 - 0.5 bar. Consequently, the dispensed amount of material can be precisely controlled, as intended, by relatively small pressure variations.

If a pressure vessel is used, the static operating pressure on the material in the material storage container can be exerted via a first pressure reducing valve, for example, and the dynamic operating pressure can be varied separately via the pressure control element. In this way the pressure vessel directly controls the static operating pressure of the material in the material storage container, and the pressure control element directly controls the dynamic operating pressure by supplying or discharging pressure fluid to and from the material storage container.

In a practical implementation of the invention, the pressure control element is an air pressure regulator arranged for controlling the pressure at the material in the material storage container by means of compressed air, for example, in which case the material in the material storage container is a liquid.

Instead of or in addition to the use of a pressure vessel containing a pressure fluid, the material in the material storage container can also be kept at an operating pressure by mechanical devices, for example by means of a piston or the like acting on the material in a closed material storage container. In yet another embodiment of the material dispensing device according to the invention, the pressure control element is coupled to the material storage container, being arranged to vary an operating volume of the material storage container. If a piston is used, the operating volume is for example varied by varying the position of the piston in the material storage container.

In yet another embodiment of the use of a pressure vessel containing a pressure fluid, the material in the material storage container may also be stored in a compressible container, for example a storage bag, in the material storage container, in which case the pressure on the storage bag can be realised both by mechanical devices and by means of a pressure fluid.

The skilled person will be able to conceive and realise further ways of volume variations by means of the pressure control element according to the invention.

In an embodiment of the invention, the material dispensing device comprises a pressure control element which can be set by means of an electrical signal and in which the flow meter provides an electrical signal corresponding to the flow rate of the material flow, as well as an electronic control unit connected to the flow meter and the pressure control element. The electronic control unit, such as a microprocessor or a microcomputer, comprises a signal input interface connected to the flow meter, a signal output interface connected to the pressure control element and a setting unit for setting a desired amount of material to be dispensed by the material flow. The control unit is arranged for controlling the pressure control element on the basis of the dispensed amount of material as determined from the flow rate measured by the flow meter and a set desired amount of material to be dispensed.

The setting unit comprises an input interface, by means of which the user can set the desired of material to be dispensed, for example. The electronic control unit is arranged to compare the dispensed amount of material with the amount set with the setting unit and to control the pressure control element on the basis thereof.

The input interface of the setting unit may comprise a software menu, for example, on a display connected to the processor or the computer, for example in the form of a touchscreen and/or a keyboard for setting a desired amount of material. On the display, the values measured by the flow meter can be displayed in comparison with the set value(s), for example in a graphic visualisation. The set values and the measured values can furthermore be stored as logging data in a memory, for example for use in quality inspections, delivery reports and the like.

In an embodiment of the invention, the control unit controls the pressure control element on the basis of the measured amount of dispensed material and the desired flow rate as set by the setting unit.

The electronic control unit can be realised with a (standard) microprocessor or microcomputer, or as a special integrated electronic circuit, among which a so-called "Very Large Scale Integrated Circuit", VLSI, or an "Application Specific Integrated Circuit", ASIC, for example as a machine-embedded circuit or other comparable technology.

In an embodiment of the invention, the flow meter is arranged to measure the dispensed amount of material on the basis of the temperature locally in the material flow.

In another embodiment of the invention, the flow meter is arranged to measure the dispensed amount of material on the basis of at least one from the group consisting of temperature differentiation techniques, ultrasonic techniques, Coriolis techniques and infrared techniques.

The flow meter comprises a channel, such as a pipe, a tube or a conduit through which the material flow passes. By carefully measuring the temperature of the material flow at two or more spaced-apart fixed measuring points of the channel, the flow rate of the material flow can be precisely calculated from the time difference between the measurement of corresponding temperatures or a corresponding variation in temperature and the known spacing between these points.

If the dimensions of the orifice of the channel through which the material flow passes are known, the amount of dispensed material can be precisely determined from the data, without components, let alone movable components, other than the channel itself being in contact or coming into contact with the material flow.

It will be understood that the determination of the dispensed amount of material from the flow rate of the material flow and the dimensions of the orifice of the channel can be carried out not only by the electronic control unit but also directly by the flow meter itself and, if necessary, by the pressure control element.

The dispensed amount of material can also be measured and determined by using other means or devices for measuring the flow rate of the material flow, as may be appreciated and known to those skilled in the art.

In an embodiment of the invention, a valve is incorporated in the material flow for starting and stopping the material flow to be dispensed at the object. The valve is the last element of the material dispensing device through which the material flow passes before the material is dispensed at the object.

In a typical example, the valve comprises an outlet opening which can be released or blocked by a needle-shaped element. The valve is used for the controlled starting and stopping of the delivery of material to the object.

In an embodiment of the invention, in which the valve is controlled by means of an electrical signal for starting and stopping the material flow, the electronic control unit is provided with a control output connected to the valve for controlling the valve.

Both the electronic control unit and the pressure control element may be arranged for controlling the valve, for example for simultaneously controlling the operating pressure on the material in the material storage container in dependence on the stopping or starting of the material flow.

In a practical embodiment of the material dispensing device according to the invention, the object is a printed circuit board, PCB, and the material is a coating material to be applied to the PCB or to a housing in which a gasket is to be placed, for example.

The present invention also relates to a material dispensing system arranged for the controlled dispensing at an object of at least one material, wherein the material dispensing system comprises a number of material dispensing devices according to the invention as described above. In this way it is possible, for example, to provide a larger amount of material distributed over several material storage containers to an object in one process stage, or to dispense various materials to an object in a simple manner.

In another embodiment, the material dispensing system according to the invention comprises a mixing chamber, which mixing chamber is arranged for mixing one or more material flows delivered by one or more material storage containers for the purpose of dispensing a mixed material flow.

The mixing chamber is arranged for mixing the various materials in the various material storage containers before they are dispensed at an object. The material dispensing system is arranged not only for dispensing the mixed material, but also for mixing the various materials from the material storage containers in a desired ratio. If an electronic control unit is used, the control unit may be arranged for controlling the mixing ratio in relation to the measured dispensed amount of material and for separately controlling the various pressure control elements.

The mixing chamber may further comprise a valve arranged for starting and stopping the delivery of the mixed material flow to the object. The mixing chamber may also comprise several valves, however, for separately starting and stopping the material flows from the various material storage containers.

In an embodiment of the material dispensing system, which is provided with processor-controlled material dispensing devices, the various electronic control units of the various material dispensing devices are advantageously integrated into a single electronic control unit. The single electronic control unit may have a control output for controlling one or more of the valves.

The invention also relates to a method for the controlled dispensing at an object of a material from a material flow from a material storage container in which the material is kept at an operating pressure, comprising the measuring of the amount of material dispensed by the material flow, characterised in that the operating pressure at the material in the material storage container is controlled on the basis of the measured dispensed amount of material.

In an embodiment in which the material in the material storage container is kept at the operating pressure by means of a pressure fluid, the operating pressure is controlled by controlling the pressure exerted at the material in the material storage container by the pressure fluid. Instead of or in addition to the use of the pressure fluid for controlling the operating pressure, the operating pressure may also be controlled by varying an operating volume of the material storage container, preferably on the basis of an adjustable desired amount of material.

The invention will now be explained in more detail with reference to the appended figures, which merely serve by way of illustration of the invention and which must not be construed as being limitative thereto.

### Brief Description of the Drawings

Figure 1 shows, in a schematic form, an example of an embodiment of the material dispensing device according to the invention.
Figure 2 shows, in a schematic form, an example of an embodiment of a part of the material dispensing system according to the invention.

### Detailed Description

The illustrated examples in particular illustrate a use of the material dispensing device in coating printed circuit boards. As the skilled person will appreciate, the invention is also quite suitable, for example, for cladding printed circuit boards, PCBs, with an insulation layer, applying lacquer or paint to an object, applying an adhesive coating or adhesive tracks, applying a barrier or sealing layer to housings, chocking components, etc.

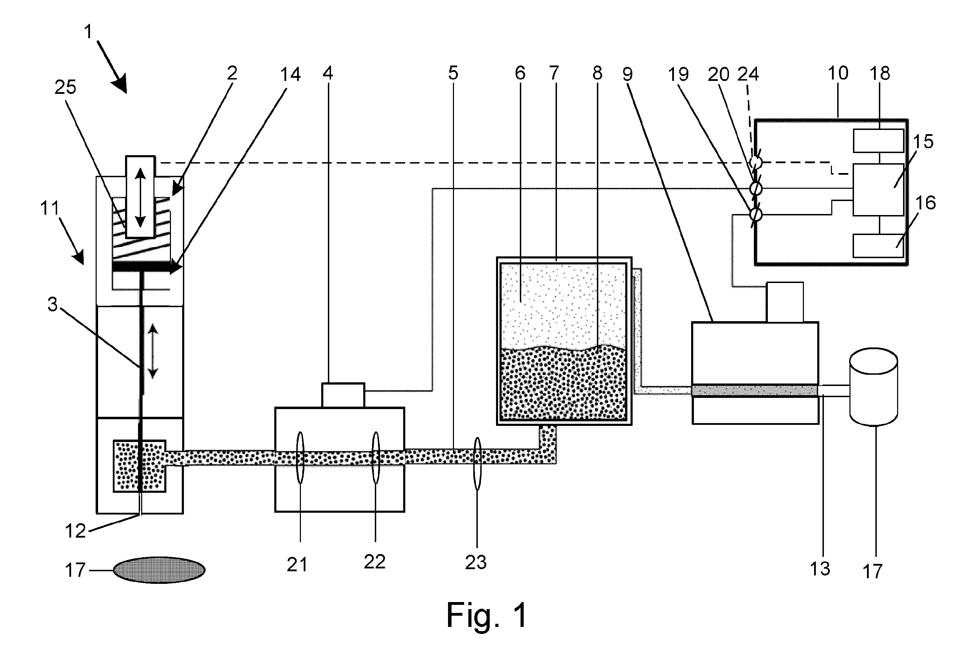

Figure 1 schematically shows an example of an embodiment of a material dispensing device 1 according to the invention for the controlled delivery of material 8. The material dispensing device 1 comprises a material storage container 7 which is arranged for keeping the material 8 at an operating pressure.

In the example of figure 1, the material 8 in the material storage container 7 is a coating material, for example, suitable for entirely or partially coating an object 17 in the form of a printed circuit board, PCB. Usual volumes of the material storage container 7 are, for example, 10 cc, 30 cc, 100 cc or 250 cc. The present invention, however, can be used with other volumes of the material storage container 7 and for other materials 8 and objects 17, as explained in the foregoing.

The material dispensing device 1 further comprises a flow meter 4 arranged for measuring the flow rate of a material flow 5 in a channel or conduit 23 from the material storage container 7 to an outlet opening 12 of a valve 11. In this example, the flow meter 4 is suitable for determining the flow rate of the material in the material flow 5 by means of a very precise measurement of the temperature or the variation in temperature of the material flow 5 and the elapsed time between corresponding temperatures at a first measuring point 22 and a second measuring point 21 spaced therefrom by a fixed and known distance, seen in the direction of flow of the material flow 5.

Although the flow meter 4 of this example is suitable for determining the flow rate of the material in the material flow 5 by means of temperature measurements, also other types of flow meters using different techniques may be used. Think in this regard, for example, of flow meters which measure the flow rate of the material on the basis of ultrasonic techniques, Doppler effects, infrared techniques, Coriolis effects, etc.

The measuring points 21, 22 engage the conduit 23 externally of the material flow 5, they are not in physical contact with the material flow. This has the advantage that the material flow in the conduit 23 is not impeded or affected anywhere by a component of the device other than the valve 11 that is arranged for starting and stopping the delivery of material to the object 17. Measurements can be carried out at more than two measuring points 21, 22, for example.

A flow meter 4 of this kind is commercially available from, among others, the company Bronkhorst High Tech, for example the LIQUI-FLOW series L101/L201. Also other types of flow meters may be used with the material dispensing device 1 according to the present invention, among which meters for measuring the flow rate of the material flow 5 based on different measuring principles, for example Coriolis techniques, as known per se to those skilled in the art.

Another flow meter suitable for use in the material dispensing device 1 is a flow meter from the company Bronkhorst High Tech, for example the "L23-ABD-00-K Digital Liquid Flow Meter" from the LIQUI-FLOW product series. The flow meter is merely mentioned as an example of many suitable flow meters for the material dispensing device 1.

As known to those skilled in the art, the amount of material delivered by the material flow 5 with the valve 11 in the open position can be essentially computed by multiplying the measured flow rate of the material flow 5 by the cross-sectional area of the conduit 23 through which the material flow 5 passes, corrected, if necessary, with correction factors for the viscosity of the material 8, the composition of the material 8 and the like.

The material dispensing device further comprises a pressure control element 9 arranged for controlling the operating pressure at the material 8 in the material storage container 7. The pressure control element 9 in this case is a pressure regulator that is known per se, which pressure regulator controls the operating pressure on the material 8 by supplying a pressure fluid 8, such as air, to the material storage container 7 or discharging the pressure fluid therefrom.

The pressure control element 9 comprises an air inlet/air outlet 13 that is connected to a pressure vessel 17 for supplying and discharging a pressure fluid 6 such as air, for example compressed air. It will be understood that also other types of pressure fluid 6 may be used, for example an inert gas or a fluid that does not reacts or interacts with the material 8 in the material storage container 7, as explained in the foregoing.

The pressure control element 9 may be a pressure regulator from the company SMC, for example article number ITV1030-31-F1CS-Q. The pressure regulator is merely an example of a large number of pressure regulators suitable for use in the material dispensing device.

Although, in the example of figure 1, the pressure fluid 6 acts on the material 8 in the material storage container 7 via the pressure control element 9 as a whole, the pressure vessel may be directly connected to the material storage container 7 via a reducing valve or the like (not shown) for exerting a static pressure component of the operating pressure on the material 8. The reducing valve may be adjustable for setting the static pressure component of the operating pressure. The pressure of the pressure fluid 6 in the pressure vessel 17 is in that case higher than the highest operating pressure in the material storage container 7. The pressure control element 9 in that case only controls the required pressure variations in dependence on the measuring results of the flow meter 4, i.e. the dynamic pressure component of the operating pressure in the material storage container 7, for the delivery of a desired amount of material 8 to the object 17. In a practical application, the applied static pressure component has a value ranging between 0 and 9 bar, whilst the dynamic pressure component is 0.01-0.5 bar.

In the embodiment shown in figure 1, the pressure control element 9 is of a type that can be adjusted by means of an electrical signal, and the flow meter 4 provides an electrical signal corresponding to the flow rate of the material flow 5 or an electrical signal directly corresponding to the amount of material dispensed to the object 17. The electrical signals may be analog or digital signals, in the form of a voltage and/or current, for example. If necessary, the communication between the various components may take place wirelessly. The material dispensing device 1 further comprises an electronic control unit 10 comprising a processor 15 having a signal input interface 20 connected to the flow meter 4 and a signal output interface 19 connected to the pressure control element 9. A setting unit 18, connected to the processor 15, is provided for setting a desired amount of material to be dispensed by the material flow 5. The setting unit 18 may have any desired form, such as menu-controlled software unit, including soft and hard buttons, a hardware unit, keyboards, touch screens and the like.

The electronic control unit 10 is arranged for controlling the pressure control element 9 on the basis of the dispensed amount of material as measured by means of the flow meter 4 and a set desired amount of material to be dispensed. Control algorithms which are known per se in practice, in particular in the field of measuring and control engineering, can be used for this purpose, which algorithms may be considered to be known to those skilled in the art. The object is to ensure that the actually dispensed amount of material will as much as possible be the same as the set amount of material to be dispensed, irrespective of the physical influences acting on the material, such as temperature, humidity level and the like, which lead to variations in the material flow, as discussed in the introduction.

Reference numeral 16 indicates an electric storage device connected to the processor 15 for storing and logging set and measured values, for example for use in quality inspections, delivery reports and the like.

To start and stop the delivery of material 8 to an object 17, the valve 11 is provided with an elongated needle- or pin-shaped piston 3, which can be moved up or down, seen in the plane of the drawing, as indicated by a double arrow. In the lower position of the piston 3, the outlet opening 12 in the valve 11 will be blocked. The blocking can be released by moving the piston 3 up, as a result of which the material 8 in the material flow 5 will be deposited on the object 17 via the outlet opening 12. A spring 25 acts on the piston 3 for keeping the valve 11 in the closed or blocked position.

The blocking and releasing of the outlet opening 12 of the valve 11 can be effected by introducing air into the deactivation opening 2 and the activation opening 14, respectively. By introducing air under pressure into the deactivation opening 2, pressure will be built up at the upper side of the piston 3, as a result of which the piston 3 will be forced down. When air is introduced via deactivation opening 14, pressure will be built up at the bottom side of the piston 3, as a result of which the piston 3 will be forced up. Valves 11 of this type are known per se in practice.

In figure 1, a piston 3 is used in a valve 11 by way of example as a means for stopping and starting the delivery of a material 8. The valve essentially functions as a shut-off valve for the material flow. As the skilled person will appreciate, there are several ways, besides the use of a piston 3, to start and stop the delivery to an object 17 of a material 8 in the material flow 5, for example by making use of other types of shut-off valves.

In another example according to the invention, movement of the piston 3 is effected electrically via the electronic control unit 10, having a control interface 24, as indicated by broken lines in figure 1. In that case the pressure on the material 8 in the material storage container 7 can be adapted simultaneously with the blocking/releasing of the outlet opening 12, if desired.

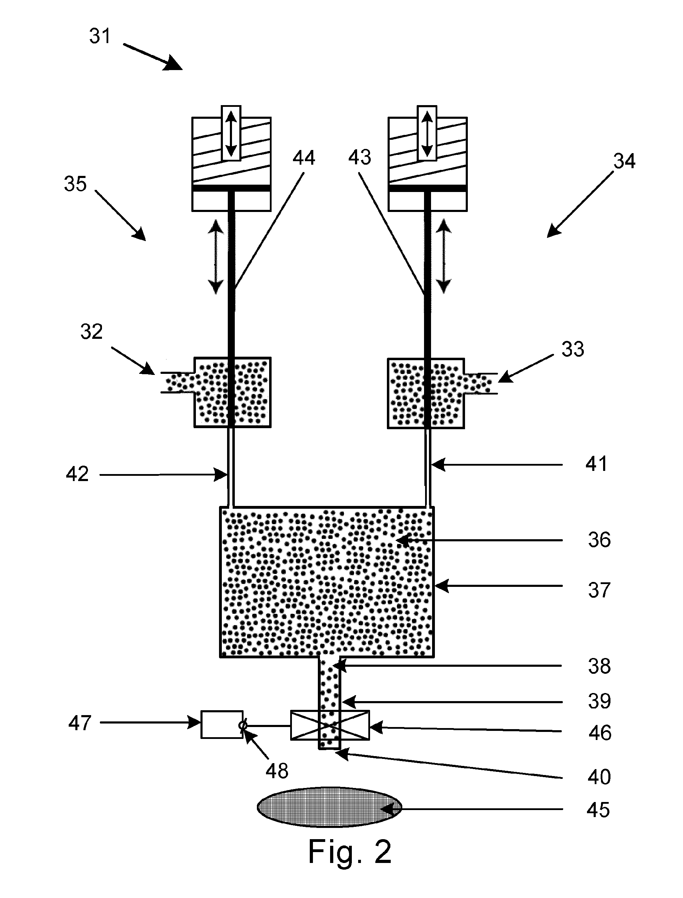

Figure 2 shows in schematic form an embodiment of a part of a material dispensing system 31 according to the invention, in which two valves 34, 35 corresponding to the valve 11 in figure 1 and a mixing chamber 37 are shown. The valves 34 and 35 form part of separate material dispensing devices as described in the foregoing. A first material in a first material flow 32 flows into the first valve 34, and a second material in a second, separate material flow 33 flows into the second valve 35. The flowing into the mixing chamber 37, via the outlet openings 41 and 42, respectively, of the materials in the two material flows 32, 33 can be started and stopped separately by means of pistons 43 and 44 of the valve 34, 35 in question. For example electrically controlled by a control unit 10 as disclosed in connection with Figure 1.

To control the material flows 32 and 33, the flow meter 4, pressure control element 9, material storage container 7 and, for example, the pressure vessel 17 shown in figure 1 are provided for each of the valves 34, 35 (not separately shown in figure 2).

When the two materials are to be mixed, the two outlet openings 41, 42 will be released, so that the materials in the material flows 32, 33 will flow into the mixing chamber 37. In the mixing chamber 37, the two materials will be mixed, so that a mixed material 36 will be formed. The mixed material 36 is further mixed in a dispensing channel 39, and eventually the thus mixed material 38 is dispensed to an object 45 via the opening 40 in the dispensing channel 39.

A further valve 46 may be placed in the dispensing channel 39 for starting or stopping the delivery of material 38 to the object 45. This valve 46 may be of the same type as the valves 11, 34, 35 and can be electrically controlled from a control interface 48 of an electronic control unit 47 of the material dispensing system 31. It is also possible, of course, to supply only one material flow 32, 33 at a time to the object 45 by suitably separately controlling the valves 34, 35.

The electronic control units 10 for each of the material dispensing devices associated with the valves 34, 35 and the electronic control unit for controlling the valve 46 may be advantageously combined into a single electronic control unit 47 of the material dispensing system 31.

A desired mixing ratio of the material 38 of the material dispensing system 31 can be controlled separately, since the material flows 32, 33 of the two materials are measured separately. In this way it is possible to control the mixing ratio in a dynamic manner.

Although not shown, more than two material dispensing devices 34, 35 according to the invention can be combined into one material dispensing system 31.

The invention further provides a method for the controlled delivery to an object 17, 45 of a material from a material flow 5, 32, 33 from a material storage container 7 in which the material is kept at an operating pressure. The amount of material dispensed by a material flow 5, 32, 33 is to that end measured, and the operating pressure on the material in the material storage container 7 is controlled on the basis of the measured dispensed amount of material and a set desired amount of material. This is for example done by controlling the pressure exerted on the material in the material storage container 7 by a pressure fluid 6 and/or by varying an operating volume of the material storage container. The latter embodiment of the invention is not explicitly shown. To those skilled in the art it is conceivable, however, to mount a piston extending across the interior cross-sectional area of the storage container 7 in the storage container, which piston is movable towards and away from the material 8, for thus exerting an operating pressure on the material 8. The operating pressure can also be realised and varied in other ways known to those skilled in the art.

The present invention has been explained in the foregoing by means of a number of examples. As those skilled in the art will appreciate, several modifications and additions can be realised without departing from the scope of the invention as defined in the appended claims.

## Claims

1. A material dispensing device for controlled dispensing at an object of a material, comprising a material storage container for keeping a material at an operating pressure so as to provide a material flow, and a flow meter for measuring an amount of material dispensed by said material flow, **characterised in that** said material dispensing device further comprises a pressure control element for controlling said operating pressure at said material in said material storage container based on a measured dispensed amount of material.

2. The material dispensing device according to claim 1, further comprising a pressure vessel connected to said material storage container, wherein said pressure vessel contains a pressure fluid for keeping said material in said material storage container at said operating pressure.

3. The material dispensing device according to claim 2, wherein said pressure control element is coupled to said pressure vessel and is arranged for controlling said operating pressure exerted at said material in said material storage container by means of said pressure fluid.

4. The material dispensing device according to one or more of the preceding claims, wherein said pressure control element is coupled to said material storage container and is arranged to vary an operating volume of the material storage container.

5. The material dispensing device according to one or more of the preceding claims, wherein said pressure control element is controlled by means of an electrical signal and said flow meter is arranged for providing an electrical signal corresponding to a flow rate of said material flow, further comprising an electronic control unit connected to said flow meter and to said pressure control element, said electronic control unit comprising a processor, signal input means connected to said flow meter, signal output means connected to said pressure control element and setting means for setting a desired amount of material to be dispensed by said material flow, wherein said control unit is arranged for controlling said pressure control element based on a dispensed amount of material determined from said flow rate measured by said flow meter and a set desired amount of material.

6. The material dispensing device according to one or more of the preceding claims, wherein said flow meter is arranged for measuring said dispensed amount of material based on-a flow rate of said material flow, said flow meter operates based on at least one from a group comprising temperature differentiation techniques, ultrasonic techniques, Coriolis techniques and infrared techniques.

7. The material dispensing device according to one or more of the preceding claims, further comprising a valve incorporated in said material flow for starting and stopping said material flow to be dispensed at said object, said valve being controlled by means of an electrical signal for starting and stopping said material flow, and an electronic control unit having a control output for controlling said valve.

8. A material dispensing system arranged for controlled dispensing at an object of at least one material, said material dispensing system comprising a number of material dispensing devices according to one or more of claims 1 - 7.

9. The material dispensing system according to claim 8, further comprising a mixing chamber arranged for mixing a plurality of material flows delivered by a plurality of material storage containers for dispensing a mixed material flow.

10. The material dispensing system according to claim 9, further comprising a valve incorporated in said mixed material flow for starting and stopping dispensing of said mixed material flow to said object, said valve being controlled by means of an electrical signal provided by an electronic control unit having a control output connected to said valve.

11. A method for controlled dispensing at an object of a material from a material flow from a material storage container in which said material is kept at an operating pressure, said method comprising measuring of an amount of material dispensed by said material flow, **characterised in that** said operating pressure at said material in said material storage container is controlled based on a measured dispensed amount of material.

12. The method according to claim 11, wherein said material in said material storage container is kept at said operating pressure by means of a pressure fluid, wherein said operating pressure is controlled by controlling pressure exerted at said material in said material storage container by said pressure fluid.

13. The method according to claim 11 or 12, wherein said operating pressure is controlled by varying an operating volume of said material storage container.

14. The method according to claim 11, 12 or 13, wherein said operating pressure is controlled based on a set desired amount of material to be dispensed.

15. The method according to claim 11, 12, 13 or 14, wherein said object to which said material is dispensed is a printed circuit board, PCB.
